Europäisches Patentamt

European Patent Office

Office européen des brevets

(19)

(11) Numéro de publication: **0 283 346**
**A1**

(12) **DEMANDE DE BREVET EUROPEEN**

(21) Numéro de dépôt: **88400378.1**

(22) Date de dépôt: **19.02.88**

(51) Int. Cl.⁴: **G 01 R 31/00**

(30) Priorité: **27.02.87 FR 8702641**

(43) Date de publication de la demande:
**21.09.88 Bulletin 88/38**

(84) Etats contractants désignés:
**AT BE CH DE ES GB GR IT LI LU NL SE**

(71) Demandeur: **Macé, Jacky**
**15, rue de la Présentation**
**F-75011 Paris (FR)**

(72) Inventeur: **Macé, Jacky**
**15, rue de la Présentation**
**F-75011 Paris (FR)**

(74) Mandataire: **Lefebure, Gérard et al**
**Office Blétry 2, boulevard de Strasbourg**
**F-75010 Paris (FR)**

(54) **Détecteur d'anomalie de fonctionnement d'un dispositif électrique, électrotechnique ou électronique.**

(57) L'invention concerne un détecteur d'anomalie de fonctionnement d'un dispositif électrique tel qu'un interrupteur de position. Le détecteur comprend principalement deux circuits d'entrée identiques (20,30), un circuit de temporisation (35), un circuit de détection et de mémorisation (45) et un circuit d'alarme (50). L'invention est applicable à la détection d'anomalie dans les interrupteurs électriques, les relais, les connexions, les interrupteurs de position, etc.

FIG. 2

EP 0 283 346 A1

## Description

Détecteur d'anomalie de fonctionnement d'un dispositif électrique, électrotechnique ou électronique.

L'invention concerne un détecteur d'anomalie de fonctionnement d'un dispositif électrique, électrotechnique ou électronique, tel qu'un connecteur, un relais, un détecteur de position ou de fin de course, ou autres actionneurs et capteurs.

Dans certaines installations électriques, électrotechniques ou électroniques, il est important de détecter la panne ou le mauvais fonctionnement de certains éléments, par exemple un connecteur, un relais, un détecteur de position ou de fin de course, afin d'effectuer rapidement la réparation pour que l'installation ne reste hors service que pendant une durée la plus courte possible. Il existe des dispositifs de détection de panne qui sont directement associés à l'élément à surveiller et qui ont un élément de visualisation s'allumant en cas de panne. Ces dispositifs de l'art antérieur ne permettent pas de déterminer la partie de l'élément qui est en panne, par exemple dans le cas d'un relais à plusieurs contacts, celui des contacts qui est affecté par la panne, ou l'usure des contacts. En outre, ils ne fonctionnent que par "tout ou rien", c'est-à-dire qu'ils ne peuvent détecter un début de mauvais fonctionnement, par exemple un temps de réponse qui augmente.

Le but de la présente invention est donc de réaliser un détecteur d'anomalie de fonctionnement d'un dispositif du type électrique, électrotechnique ou électronique, qui permet non seulement de détecter la panne, mais aussi de déterminer la partie du dispositif qui est en panne ou qui, sans être en panne, fonctionne de manière anormale.

L'invention se rapporte à un détecteur d'anomalie de fonctionnement d'un dispositif électrique, caractérisé en ce qu'il comprend deux paires de bornes d'entrée qui sont connectées audit dispositif électrique, deux circuits d'entrée reliés chacun à un paire de bornes d'entrée, un circuit horloge, un circuit de comptage-décodage des impulsions fournies par le circuit horloge, un circuit de détection et de mémorisation d'anomalie recevant les signaux fournis par lesdits circuits d'entrée et par le circuit de comptage-décodage et un circuit d'alarme recevant les signaux de sortie dudit circuit de détection et de mémorisation pour signaler l'anomalie constatée.

Selon l'invention, chaque paire de bornes d'entrée comprend une borne d'entrée directe et une borne d'entrée complémentée, la connexion du dispositif électrique étant réalisée à l'une ou l'autre borne de chaque paire de bornes d'entrée, selon le niveau de tension sur l'un des deux contacts dudit dispositif électrique, et celle des deux bornes complémentées qui n'est pas utilisée est connectée à un potentiel positif.

Chaque circuit d'entrée comprend un circuit bistable qui est à l'état 0 lorsque le dispositif électrique est au repos et qui passe à l'état 1 lorsque ledit dispositif électrique passe à l'état travail.

Le circuit bistable d'un circuit d'entrée qui passe le premier à l'état 1 par suite du changement d'état d'un contact, provoque le comptage par le circuit de comptage-décodage des impulsions fournies par le circuit horloge de manière à fournir une indication de temps entre le changement d'état du premier contact et le changement d'état du deuxième contact connecté au circuit bistable de l'autre circuit d'entrée. Ainsi, une anomalie est détecté lorsque le deuxième contact n'a pas changé d'état dans un délai prédéterminé T1.

Egalement, à l'aide de ce circuit de comptage-décodage, une anomalie est détectée lorsque le deuxième contact change d'état après un délai prédéterminé T2 (supérieur à T1), indiquant que le fonctionnement du dispositif électrique est trop long.

Une troisième anomalie est détectée lorsque le deuxième contact change d'état alors que le premier contact n'a pas changé d'état.

Ces différentes anomalies peuvent être par exemple signalées par l'allumage d'une ou de deux sources lumineuses ou des deux à la fois.

Grâce au circuit de comptage-décodage, chaque cycle de surveillance est répétitif et dure un temps prédéterminé.

De manière plus générale, le détecteur d'anomalie de fonctionnement selon l'invention permet de détecter une anomalie entre deux points d'un circuit électrique, ces deux points étant connectés par un dispositif quelconque tel qu'un connecteur, un interrupteur, un relais, etc. et de déterminer le type d'anomalie tel qu'un délai de fonctionnement trop long.

D'autres caractéristiques et avantages de la présente invention apparaîtront à la lecture de la description suivante d'un exemple particulier de réalisation effectuée en relation avec les dessins ci-annexés dans lesquels :
- la figure 1a représente schématiquement un l'interrupteur de position au repos;
- la figure 1b représent schématiquement l'interrupteur de position de la figure 1a en position travail;
- la figure 2 est un schéma électrique d'un détecteur d'anomalie de fonctionnement selon l'invention, et
- la figure 3 est un schéma montrant les liaisons à effectuer entre un interrupteur à surveiller et le détecteur d'anomalie de fonctionnement selon l'invention.

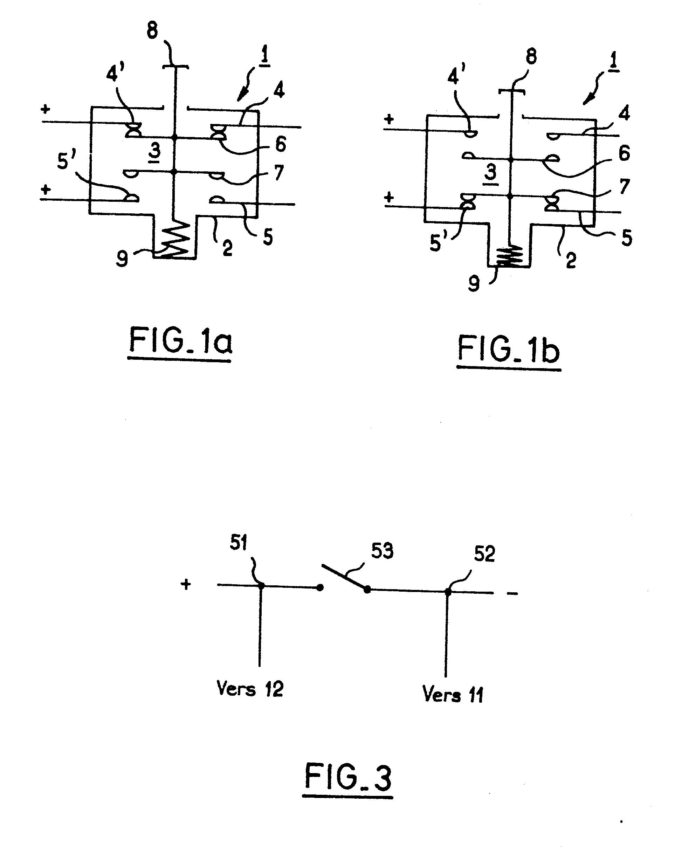

Les figures 1a et 1b représentent un même interrupteur de position 1, l'une en position repos et l'autre en position travail, qui sera utilisé pour expliquer le fonctionnement du détecteur d'anomalie selon la présente invention. Cet interrupteur de position 1 comprend un corps 2 présentant une cavité 3, deux paires de contacts fixés 4,4' et 5,5' disposées l'une en haut de la cavité 3 et l'autre en bas, et deux contacts mobiles 6 et 7 solidaires d'un bouton poussoir 8 associé à un ressort 9 travaillant en compression.

Comme le montre la figure 1a, en position repos, le ressort 9 étant détendu, le contact mobile 6 engage les contacts fixes 4 et 4', tandis que le contact mobile 7 ne touche pas les contacts fixes 5 et 5'. Lorsque le bouton-poussoir 8 est déplacé vers le bas, le contact mobile 6 se sépare d'abord des contacts fixes 4 et 4'. Après une durée qui dépend de la vitesse de déplacement du bouton-poussoir 8, le contact mobile 7 vient engager les contacts fixes 5 et 5'. Le relâchement du bouton-poussoir 8 provoque d'abord une ouverture des contacts 5 et 5' suivie d'une fermeture des contacts 4 et 4'.

Dans un tel interrupteur de position dont le contact est à action dépendante (rupture lente), on comprend que l'usure des contacts provoque une augmentation de la course d'approche des contacts associés et de la course différentielle et donc des temps de réponse plus longs pour une vitesse de déplacement constante du bouton poussoir. Il est donc important de surveiller l'évolution du temps de réponse et fournir un signal d'alarme lorsque ce temps dépasse un certain seuil.

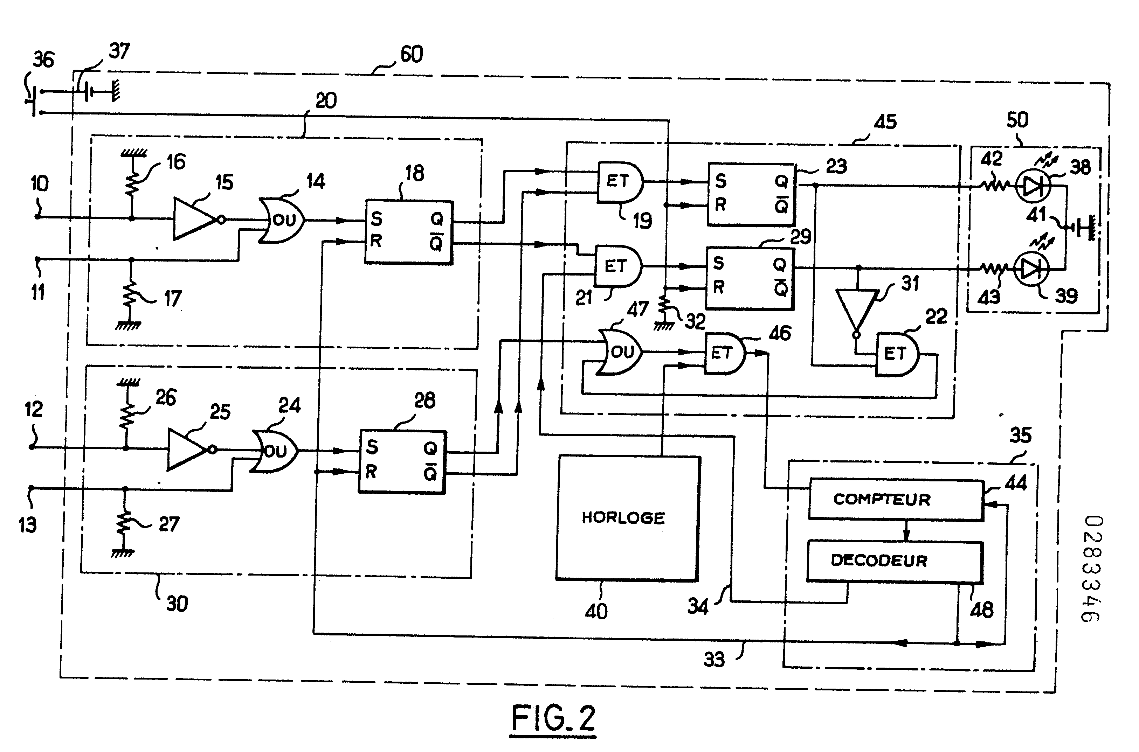

Le détecteur d'anomalie de fonctionement 60 selon l'invention, qui sera maintenant décrit en relation avec la figure 2, permet d'élaborer un tel signal d'alarme; un signal d'alarme apparaît également lorsque l'un ou l'autre contact ne se fait pas, c'est-à-dire une anomalie "tout ou rien" alors que dans le premier cas, il s'agit d'une anomalie qui n'entrave que partiellement le fonctionnement de l'interrupteur de position et qui est en quelque sorte une anomalie qui permet d'effectuer une action préventive.

Le détecteur d'anomalie 60 (figure 2) comprend, de manière très schématique, deux paires de bornes d'entrée 10,11 et 12,13, deux circuits d'entrée 20 et 30 dont les entrées sont constituées respectivement par lesdites paires de bornes d'entrée 10,11 et 12,13, un circuit de comptage-décodage 35, un circuit horloge 40, un circuit de détection et de mémorisation des défauts 45 et un circuit de visualisation des défauts détectés 50.

Chaque circuit d'entrée 20 ou 30 comprend un circuit logique OU 14 (24 pour le circuit 30) dont les deux entrées sont connectées, l'une directement à la borne d'entrée 11 (13) et à une résistance 17 (27) et l'autre à la borne d'entrée 10 (12) et à la résistance 16 (26) par l'intermédiaire d'un circuit inverseur 15 (25). Il comprend également un circuit bistable 18 (28) dont l'entrée de commande S est connectée à la sortie du circuit OU 14 (24), tandis que l'entrée de remise à zéro R est connectée à une première sortie 33 du circuit de comptage-décodage 35.

Le circuit de détection et de mémorisation des défauts 45 comprend quatre circuits ET 19,21,22 et 46, deux circuits bistables 23 et 29, un circuit inverseur 31, un circuit OU 17 et une résistance 32. Les deux entrées du circuit ET 19 sont connectées, l'une à la sortie Q du circuit bistable 18 et l'autre à la sortie Q̄ du circuit bistable 28; la sortie du circuit ET 19 est connectée à l'entrée de commande S du circuit bistable 23. La sortie Q du circuit bistable 23 est connectée, d'une part, au circuit de visualisation 50 et, d'autre part, à une des deux entrées du circuit ET 22.

Les deux entrées du circuit ET 21 sont connectées l'une à la sortie Q̄ du circuit bistable 18 et l'autre à une deuxième sortie 34 du circuit de comptage-décodage 35. La sortie du circuit ET 21 est connectée à l'entrée de commande S du circuit bistable 29 dont la sortie Q est connectée, d'une part, au circuit de visualisation 50 et, d'autre part, à la deuxième entrée du circuit ET 22 par l'intermédiaire du circuit inverseur 31.

Le circuit ET 46 reçoit sur une entrée des impulsions fournies par le circuit horloge 40 et sur l'autre entrée le signal de sortie d'un circuit OU 47. Une des deux entrées du circuit OU 47 est connectée à la sortie Q du circuit bistable 28 tandis que l'autre entrée est connectée à la sortie du circuit ET 22.

Une commande de remise à zéro, par exemple un bouton poussoir 36 disposé sur le boîtier du détecteur d'anomalie 60, est connectée à chaque entrée R des deux circuits bistables 23 et 29, à leur résistance 32 et à une borne 37 à un potentiel positif.

Le circuit de visualisation 50 comprend, par exemple, deux diodes émettrices de lumière 38 et 39 connectées d'un côté à une borne de potentiel négatif 41 et, de l'autre côté, à la sortie Q du circuit bistable 23 pour la diode 38 par l'intermédiaire d'une résistance 42 et à la sortie Q du circuit bistable 29 pour la diode 39 par l'intermédiaire d'une résistance 43.

Le circuit de comptage-décodage 35 comprend un compteur 44 qui reçoit les impulsions du circuit horloge 40 par l'intermédiaire d'un circuit ET 46.

Le circuit de comptage-décodage 35 comprend également un décodeur 48 dont les entrées sont connectées au compteur 44 et dont on utilise deux sorties décodées 33 et 34.

Le circuit horloge 40 est de type classique et ne sera pas décrit de manière plus détaillée.

Pour surveiller le fonctionnement de l'interrupteur de position de la figure 1, les liaisons à effectuer sont les suivantes. Le contact fixe 4 doit être connecté à la borne d'entrée 12, le contact fixe 5 doit être connecté à la borne d'entrée 11 et la borne 10 doit être connectée à un potentiel positif, par exemple au contact 4' ou 5' pour forcer la sortie de l'inverseur 15 à zéro. Les critères qui permettent de choisir les liaisons à effectuer seront expliqués et définis ci-après.

Le fonctionnement du détecteur d'anomalie de la figure 2 est alors le suivant, dans le cas où le dispositif électrique à surveiller est l'interrupteur de position de la figure 1.

Avant le déplacement du bouton-poussoir 8, c'est-à-dire lorsque l'interrupteur est au repos, le circuit est établi entre les contacts 4,4' et 6 de sorte que, par l'effet du circuit inverseur 25, le circuit bistable 28 reste à l'état 0 (Q=0). En conséquence, le circuit ET 46 reste bloqué et aucune impulsion du signal de l'horloge 40 n'est appliquée au compteur 44. Au repos, le circuit entre les contacts 5,5' et 7 de l'interrupteur est ouvert de sorte que le circuit bistable 18 est à l'état 0 (Q = 0), ce qui ouvre le circuit ET 21, mais ferme le circuit ET 19. L'ouverture du circuit ET 21 n'a aucun effet sur le circuit bistable 29 car, comme le compteur 44 n'est pas alimenté en impulsions, il ne fournit pas de signal sur la sortie 34.

Les explications ci-dessus montrent que le détecteur d'anomalie ne réalise pas de surveillance lorsque l'interrupteur de position, et plus généralement, le dispositif électrique à surveiller, est à l'état repos.

Ces explications montrent également que les liaisons à réaliser entre le dispositif électrique à surveiller et les bornes d'entrée 10, 11, 12 et 13 doivent l'être pour que, à l'état repos du dispositif électrique, le détecteur 60 reste inerte. Ces liaisons dépendent donc des niveaux électriques présents dans le dispositif électrique à surveiller. Elles dépendent également de l'événement qui va se produire en premier lorsque le dispositif électrique passera à l'état travail. En effet, comme le fonctionnement le montrera, il est important que le compteur 44 soit mis en marche dès l'actionnement du dispositif électrique. Or, cette mise en marche est commandée par le circuit bistable 28 connectée à la paire de bornes d'entrée 12 et 13. Il en résulte que l'une ou l'autre des bornes 12, 13 doit être connectée au contact du dispositif électrique qui change d'état le premier.

Avec l'interrupteur de position de la figure 1, le premier événement, lorsqu'on presse le bouton-poussoir 8, est l'ouverture du circuit entre les contacts 4,4' et 6, c'est donc le contact 4 qui doit être connecté à l'une des bornes 12 ou 13; comme le contact 4 est à un niveau positif, il n'aura aucun effet à l'état repos sur le circuit bistable 28 s'il est connecté à la borne 12. Le deuxième événement, lorsque le bouton-poussoir 8 est actionné, est la fermeture du circuit entre les contacts 5,5' et 7, de sorte que le contact 5 doit être connecté à l'une des bornes d'entrée 10 ou 11, et plus précisément à la borne 11, car au repos, le contact 5 est à un potentiel flottant, mais la borne 11 est polarisée à la masse par la résistance 17.

Le déplacement du bouton-pressoir 8 ouvre d'abord le circuit entre les contacts 4,4' et 6, de sorte que la sortie du circuit inverseur 25 fournit un signal qui, à travers le circuit OU 24, met le circuit bistable 28 à l'état 1 (Q = 1), de sorte que le circuit ET 46 s'ouvre et laisse passer les impulsions du signal du circuit horloge 40 vers le compteur 44. Si l'interrupteur de position n'a pas de défaut, le circuit entre les contacts 5,5' et 7 se ferme un certain laps de temps après l'ouverture du circuit entre les contacts 4,4' et 6, ce qui a pour effet de mettre le circuit bistable 18 à l'état 1 ( $\overline{Q}$ = 0) et de fermer le circuit ET 21. Par ailleurs, le passage à l'état 1 du circuit bistable 18 (Q = 1) n'a aucun effet sur le circuit ET 19 car ce dernier reçoit un signal de fermeture de la sortie $\overline{Q}$ = 0 du circuit bistable 28. Il en résulte qu'aucun signal ne peut changer l'état des circuits bistables 23 et 29 et aucun signal d'alarme n'apparaît.

Si la fermeture du circuit entre les contacts 5,5' et 7 de l'interrupteur de position s'effectue au-delà d'un certain délai T1 après l'ouverture du circuit entre les contacts 4,4' et 6, il est prévu d'indiquer qu'il s'agit d'un défaut. Ceci est obtenu en mesurant à l'aide du compteur 44 le temps qui s'écoule après l'ouverture du circuit entre les contacts 4,4' et 6 et en fournissant un signal sur la sortie 34 du circuit décodeur 48 lorsque le délai T1 est atteint. Comme le circuit ET 21 est ouvert par le signal $\overline{Q}$ = 1 du circuit bistable 18, le signal sur la sortie 34 met le circuit bistable 29 à l'état 1 (Q = 1), ce qui allume la diode émettrice 39 et indique qu'il y a une anomalie ou un défaut au niveau des contacts 5,5' et 7.

Au-delà d'un certain délai T2 supérieur à T1, le circuit décodeur 48 fournit sur la sortie 33 un signal de remise à zéro au compteur 44 et aux circuits bistables 18 et 28, ce qui a pour effet de fermer les circuits ET 19, 21 et 46 mais ne modifie pas l'état du circuit bistable 29 qui continue à indiquer un défaut.

On remarquera que ce signal de remise à zéro sur la sortie 33 apparaît à chaque cycle du détecteur d'anomalie de manière que ce dernier soit prêt à surveiller le fonctionnement de l'interrupteur lors d'un actionnement ultérieur du bouton-poussoir.

Si le circuit entre les contacts 5,5' et 7 se ferme alors que le circuit entre les contacts 4,4' et 6 n'est pas ouvert, le circuit bistable 18 passe à l'état 1 alors que le circuit bistable 28 reste à l'état 0 ( $\overline{Q}$ = 1). Ceci a pour conséquence d'ouvrir le circuit ET 19, de mettre le circuit bistable 23 à l'état 1 (Q = 1) et d'allumer la diode émettrice 38 qui indique un défaut sur les contacts 4,4' et 6. Comme le circuit bistable 29 est à l'état 0, le circuit ET 22 fournit un signal qui ouvre le circuit ET 46 de sorte que le compteur 44 reçoit les impulsions du circuit horloge 40. En fin de cycle, la sortie 33 du circuit décodeur fournit un signal de remise à zéro, notamment au circuit bistable 18 qui revient à l'état initial. On remarquera que le signal sur la sortie 34, antérieur au signal sur la sortie 33, n'a aucun effet car le circuit ET 21 reçoit le signal $\overline{Q}$ = 0 de l'état 1 du circuit bistable 18.

Comme autre cas d'anomalie de fonctionnement de l'interrupteur de position, il peut se produire que le circuit entre les contacts 5,5' et 7 ne se ferme pas avant le délai T1, d'où allumage de la diode 39, mais se ferme ensuite, après la remise à zéro des circuits bistables 18 et 28. Le circuit bistable 18 passe alors à l'état 1 (Q = 1) lors de la fermeture des contacts 5,5' et 7 de sorte que le circuit ET 19 fournit un signal de commande du circuit bistable 23, qui passe à l'état 1 (Q = 1), ce qui allume la diode émettrice 38. Les deux diodes 38 et 39 sont donc allumées, ce qui indique que le fonctionnement de l'interrupteur de position est trop long.

Dans tous les cas où une anomalie apparaît, l'une des deux diodes 38 ou 39, ou les deux, s'allument et ne peuvent s'éteindre que si un opérateur vient actionner le bouton de remise à zéro 36 qui est connecté à l'entrée de la remise à zéro R des circuits bistables 23 et 29. Bien entendu, si le défaut n'a pas été effectivement réparé par l'opérateur, la (ou les) diodes) s'allume à nouveau.

Le détecteur d'anomalie selon l'invention a été décrit, notamment en ce qui concerne son fonctionnement, en relation avec un interrupteur de position faisant office de dispositif électrique à surveiller. Cependant, il est clair que ce détecteur d'anomalie peut être utilisé pour surveiller d'autres dispositifs électriques, électroniques, électromécaniques ou encore électrotechniques. C'est ainsi que le dispositif peut être un interrupteur électrique 53 (figure 3) entre deux points 51 et 52 qui est par exemple ouvert en position repos. Dans ce cas, le point 51 est connecté à la borne d'entrée 12 et le point 52 à la borne d'entrée 11. Par ces connexions, le détecteur d'anomalie est inerte car les circuits bistables 18 et 28 restent à l'état 0. En cas de fermeture de l'interrupteur 53, il y a d'abord une fluctuation du niveau de potentiel en 51, ce qui provoque l'état 1 du circuit bistable 28 et donc la mise en marche du compteur 44. Ensuite, le point 52 passe à un niveau positif, ce qui provoque l'état 1 du circuit bistable 18. Si le changement à l'état 1 du circuit bistable 18 s'effectue dans le délai déterminé par le signal sur la sortie 34, aucun signal d'alarme n'apparaît. S'il n'en est pas ainsi, le circuit bistable 29 change d'état lorsque la sortie 34 est activée et la diode 39 s'allume pour indiquer une alarme.

On remarquera que le même signal d'alarme apparaîtra si l'interrupteur 53 étant au repos, le point 51 n'est plus au niveau positif pour une raison quelconque.

Ainsi, pour surveiller un interrupteur 53 (figure 3), un seul circuit de visualisation est nécessaire.

L'invention a été décrite avec un circuit comportant un compteur associé à un décodeur pour donner une indication de délai entre deux événements. Il est clair que l'invention couvre également le cas où le compteur est remplacé par un circuit de temporisation de type quelconque.

L'invention a été décrite dans une fonction de surveillance, c'est-à-dire en se contentant de fournir des indications sur l'existence d'anomalie; il est clair que les informations recueillies peuvent être ensuite utilisées de manière active, c'est-à-dire en occasionnant une action sur le dispositif électrique lui-même ou en mettant en service un dispositif électrique de rechange qui était jusque là en attente. On peut également utiliser le détecteur pour donner une information de bon fonctionnement par une visualisation appropriée tant qu'une anomalie n'est pas détectée. Au lieu d'utiliser des diodes électroluminescentes pour signaler les anomalies, on peut aussi utiliser une ou plusieurs alarmes sonores.

**Revendications**

1.- Détecteur d'anomalie de fonctionnement d'un dispositif électrique de commutation (1), comprenant des premier et second circuits d'entrée (30,20) reliés respectivement à des premier et second éléments (4,5) du dispositif électrique (1) à surveiller, ledit premier élément (4) changeant normalement d'état avant ledit second élément (5) quand le dispositif électrique (1) à surveiller passe de l'état de repos à l'état de travail, un circuit de détection d'anomalie (45) relié aux premier et second circuits d'entrée (30,20), et un circuit d'alarme (50) comportant deux moyens d'alarme (38,39) reliés respectivement à deux sorties du circuit de détection d'anomalie (45), caractérisé en ce que les premier et second circuits d'entrée (30,20) comprennent respectivement des premier et second circuits bistables (28,18) ayant des premières entrées (S) qui sont respectivement connectées aux premier et second éléments (4,5) du dispositif électrique (1) à surveiller, de façon à passer à l'état "0" à l'état "1" en réponse audit changement d'état desdits premier et second éléments (4,5) respectivement, en ce qu'il est prévu un circuit de temporisation (35), qui est relié à une première sortie (Q) du premier circuit bistable (28) et qui, en réponse au passage de l'état "0" à l'état "1" dudit premier circuit bistable, produit un premier signal après un premier délai prédéterminé (T1) sur une première sortie (34) et un second signal sur une seconde sortie (33) après un second délai prédéterminé (T2) plus grand que ledit premier délai, ladite seconde sortie (33) étant reliée à des secondes entrées de remise à zéro (R) des premier et second circuits bistables (28,18), et en ce que le circuit de détection d'anomalie (45) comprend un premier circuit ET (19) dont une entrée est connectée à une première sortie (Q) du second circuit bistable (18) et dont une autre entrée est conenctée à une seconde sortie $\overline{Q}$ du premier circuit bistable (28), un deuxième circuit ET (21) dont une entrée est connectée à une seconde sortie $\overline{Q}$ du second circuit bistable (18) et dont une autre entrée est connectée à la première sortie (34) du circuit de temporisation (35), un troisième circuit bistable (23) dont une entrée (S) est connectée à la sortie du premier circuit ET (19), et dont une sortie (Q) est connectée à un premier moyen d'alarme (38) du circuit d'alarme (50), et un quatrième circuit bistable (29) dont une entrée (S) est connectée à la sortie du deuxième circuit ET (21) et dont une sortie (Q) est connectée à un second moyen d'alarme (39) du circuit d'alarme (50) de telle sorte que le premier moyen d'alarme (38) est activé quand le second circuit bistable (18) passe à l'état "1" alors que le premier circuit bistable (28)) est resté à l'état "0", dénotant un défaut de fonctionnement du premier élément (4) du dispositif électrique (1) à surveiller, que le second moyen d'alarme (39) est activé quand le second circuit bistable (18) n'est pas passé de l'état "0" à l'état "1" à la fin du premier délai prédéterminé (T1), dénotant un défaut de fonctionnement du second élément (5) du dispositif électrique (1) à surveiller, et que les deux moyens d'alarme (38 et 39) sont activés quand le second circuit bistable (18) passe de l'état "0" à l'état "1" seulement après le second délai prédéterminé (T2), dénotant un temps de fonctionnement trop long dudit dispositif électrique (1) à surveiller.

2.- Détecteur d'anomalie selon la revendication 1, caractérisé en ce que chacun des premier et second circuits d'entrée (30 et 20) comporte deux bornes d'entrée (12 et 13 ou 10 et 11) qui sont connectées d'une part, à la masse par des résistances respectives (26 et 27 ou 16 et 17) et, d'autre part, l'une (13 ou 11) directement, l'autre (12 ou 10) par un circuit inverseur (25 ou 15) aux entrées d'un circuit OU (24 ou 14), dont la sortie est reliée à la première entrée (S) du circuit bistable (28 ou 18) correspondant des premier et second circuits d'entrée.

3.- Détecteur d'anomalie selon la revendication 1 ou 2, caractérisé en ce qu'il comprend une horloge (40) et un troisième circuit ET (46) ayant une première entrée reliée à la sortie de l'horloge (40) et une seconde entrée reliée à la première sortie (Q) du premier circuit bistable (28), et en ce que le circuit de temporisation (35) comprend un compteur (44) ayant une entrée de comptage reliée à la sortie du troisième circuit ET (46) et une entrée de remise à zéro, et un décodeur (48) ayant des entrées reliées aux sorties du compteur (44) et deux sorties formant les première et seconde sorties (34 et 33) du circuit de temporisation, la seconde sortie (33) étant en outre reliée à l'entrée de remise à zéro du compteur (44).

4.- Détecteur d'anomalie selon la revendication 3, caractérisé en ce qu'il comprend en outre un quatrième circuit ET (22) ayant une première entrée reliée à la sortie (Q) du troisième circuit bistable (23) et une seconde entrée reliée par un circuit inverseur (31) à la sortie (Q) du quatrième circuit bistable (29), et un circuit OU (47) ayant une première entrée reliée à la première sortie (Q) du premier circuit bistable (28), une seconde entrée reliée à la sortie du quatrième circuit ET (22) et une sortie reliée à la seconde entrée du troisième circuit ET (46).

5.- Détecteur d'anomalie selon l'une quelconque des revendications 1 à 4, caractérisé en ce qu'il comprend un bouton de remise à zéro (36) connecté à des entrées de remise à zéro (R) des troisième et quatrième circuits bistables (23 et 29).

0283346

FIG.1a          FIG.1b

FIG.3

FIG.2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | US-A-4 319 193 (BOCCALI) <br> * Colonne 8, ligne 9 - colonne 11, ligne 29; figures 1-5,7-9 * | 1 | G 01 R 31/00 |
| A | US-A-3 771 048 (BOND) <br> * Colonne 3, lignes 5-33; figure 3 * | 1,2 | |
| A | GB-A-2 079 466 (UNITED TECHNOLOGIES) <br> * page 2, lignes 20-123; figure 1 * | 1,3,5 | |
| A | IBM TECHNICAL DISCLOSURE BULLETIN, vol. 25, no. 7A, décembre 1983, pages 3211-3212, New York, US; R.M. COVEY et al.: "Relay tester for a microminiature relay" <br> * En entier * | 1,3,5 | |
| A | US-A-3 988 664 (BEERY) <br> * Colonne 7, ligne 15 - colonne 8, ligne 23; colonne 10, ligne 23 - colonne 12, ligne 39; figures 6-9 * | 1,2 | |
| A | IBM TECHNICAL DISCLOSURE BULLETIN, vol. 9, no. 4, septembre 1966, page 367, New York, US; M.F. HEILWEIL et al.: "Testing electromagnetic switching devices" <br> * En entier * | 1 | DOMAINES TECHNIQUES RECHERCHES (Int. Cl.4) <br><br> G 01 R 31/00 |
| A | EP-A-0 080 857 (BRITISH NUCLEAR FUELS) <br> * Page 10, ligne 1 - page 13, ligne 4; figures 3a,3b * | 3,5 | |

Le présent rapport a été établi pour toutes les revendications

| Lieu de la recherche | Date d'achèvement de la recherche | Examinateur |
|---|---|---|
| LA HAYE | 08-06-1988 | TRELEVEN C. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)